# FASCICULE DE BREVET EUROPEEN

(11) **EP 3 108 725 B1**
(45) Date de publication et mention de la délivrance du brevet: **01.07.2020**
(21) Numéro de dépôt: 15705822.3
(22) Date de dépôt: 20.02.2015
(51) Int. Cl.: H05K 7/14

(54) **BOÎTIER DE DISTRIBUTION ÉLECTRIQUE COMPRENANT UNE BARRE DE DISTRIBUTION DE PUISSANCE D'ENTRÉE**
LEISTUNGSVERTEILERKASTEN MIT EINER EINGANGSLEISTUNGSSAMMELSCHIENE
ELECTRICAL DISTRIBUTION BOX COMPRISING AN INPUT POWER BUSBAR

(30) Priorité: 21.02.2014 FR 1451394
(43) Date de publication de la demande: 28.12.2016
(73) Titulaire: Zodiac Aero Electric, 93100 Montreuil (FR)
(72) Inventeur: DESHAYES, Olivier, F-93100 Montreuil (FR)
(74) Mandataire: Casalonga
(86) Numéro de dépôt international: PCT/EP2015/053609
(87) Numéro de publication internationale: WO 2015/124722

(56) Documents cités:
- EP-A2- 1 973 018
- WO-A2-2013/045809
- US-A1- 2003 016 520
- US-A1- 2009 273 234

## Description

L'invention concerne les boîtiers de distribution d'énergie électrique, et plus particulièrement un boîtier de distribution électrique utilisant des modules de distribution électrique amovibles.

Un aéronef possède en général un système électrique comprenant notamment un circuit de distribution primaire d'énergie électrique et un circuit de distribution secondaire d'énergie électrique. Ces circuits de distribution primaire ou secondaire, aussi appelés boîtiers de distribution primaire ou secondaire, permettent de protéger et de distribuer la puissance électrique provenant de sources internes, par exemple des générateurs ou des batteries, ou de sources externes, telles que des unités de puissance ou un groupe de parc, vers des charges utiles ou vers d'autres boîtiers de distribution de l'aéronef.

Un boîtier de distribution primaire comprend généralement une partie puissance, permettant de gérer les fortes puissances électriques, et une partie électronique. La partie puissance relaie à l'aide de câbles l'énergie produite à partir de générateurs électriques entraînés par des moteurs.

Un boîtier de distribution secondaire est généralement utilisé dans un aéronef pour distribuer l'énergie électrique d'une source primaire vers différents systèmes de l'aéronef. Un boîtier de distribution secondaire comprend généralement un châssis fixé sur un support dans un véhicule tel qu'un aéronef, le châssis comportant une pluralité de logements permettant d'accueillir des modules de puissance et/ou des modules de commande électronique. Les modules de puissance sont généralement des cartes de régulation de puissance électronique, qu'on nomme également cartes SSPC (de l'anglais Solid State Power Controller), qui peuvent être configurées pour délivrer un courant alternatif ou continu. Les modules de commande électronique logés dans le boîtier de distribution secondaire permettent généralement de commander les fonctions électroniques à basse puissance, telles que la communication, et les calculs par exemple.

Les modules de puissance interagissent avec les modules de commande électronique pour fournir la puissance nécessaire pour la commande des différents éléments électriques et électroniques de l'aéronef.

En général, les interfaces électriques d'un boîtier de distribution secondaire sont réalisées à l'aide de connecteurs câblés. Il existe deux types de connecteurs : un connecteur de puissance pour connecter les modules au faisceau de câblage, dénommé également harnais électrique dans les avions (wiring harness en anglais), et un connecteur de commande pour connecter les modules à la carte mère.

Chaque carte SSPC est composée d'un connecteur de puissance et d'un connecteur de commande. Le connecteur de puissance est connecté, d'une part, au boîtier de distribution secondaire via la carte SSPC et, d'autre part, au harnais électrique.

Généralement, le harnais électrique est monté à l'intérieur du boîtier de distribution secondaire pour connecter les câbles de puissance aux modules correspondants. Une telle configuration présente l'inconvénient que lorsqu'un module est défaillant et doit être remplacé, il faut retirer le boîtier de distribution secondaire dans son intégralité et décâbler entièrement le harnais électrique pour réparer ou remplacer le module défaillant. Ce qui entraîne un coût temporel important notamment lors du remontage du boîtier de distribution secondaire dans l'aéronef. En outre, chaque câblage du harnais électrique doit être testé.

Il est connu du document US 2003/0016520 un système de distribution électrique comprenant des boîtiers de distribution secondaire réalisées de manière à ce que les cartes SSPC puissent être individuellement retirées pour une réparation ou un remplacement du boîtier de distribution secondaire.

Cependant, dans ce document, le boîtier de distribution secondaire utilise un unique connecteur pour connecter le faisceau de câbles du harnais électrique. L'utilisation d'un unique connecteur empêche toute séparation entre la partie puissance amont et la partie puissance de distribution en aval du boîtier de distribution.

De plus, le type de connecteur utilisé oblige à multiplier les protections nécessaires pour la puissance amont dans la distribution primaire car tous les fils doivent être protégés.

La multiplication des connectiques sur les cartes SSPC, et des protections dans les boîtiers de distribution primaire accroissent considérablement la masse totale du système électrique.

Par ailleurs, pour les fortes puissances, il n'est pas possible de passer par les connectiques câblées étant donné le coût et la forme rectangulaire des contacts.

Les contraintes de positionnement des connecteurs de puissance pour le harnais électrique et des connecteurs de commande pour la carte mère imposent des solutions de centrage et de rattrapage coûteuses.

Enfin, les coûts totaux des connecteurs pour un boîtier de distribution secondaire représentent un pourcentage important du coût total d'un boîtier de distribution secondaire.

Le document EP 1 973 018 A2 décrit un boîtier de distribution électrique comprenant des modules de puissance.

L'invention proposée vise à palier les inconvénients mentionnés ci-dessus en remplaçant le connecteur de puissance d'entrée par une barre de distribution de manière à optimiser les interfaces des boîtiers de distribution secondaire.

Selon un aspect de l'invention, il est proposé un boîtier de distribution électrique comprenant des premiers logements pour accueillir des modules de puissance et des seconds logements pour accueillir des modules de commande électronique, et une interface permettant de réaliser les connexions entre les différents modules et des éléments électriques externes.

Selon une caractéristique générale de l'invention, l'interface comprend au moins une barre de distribution de puissance d'entrée s'étendant dans au moins un premier logement de manière à pouvoir être raccordée à au moins un module de puissance, une barre de distribution d'entrée étant apte à être raccordée à un câble d'un harnais électrique de manière à connecter au moins un module de puissance au harnais électrique.

Une barre de distribution, ou barre de puissance, est une barre conductrice à laquelle sont couplés, d'une part, une source d'énergie électrique, et, d'autre part, différents organes électriques auxquels est distribuée l'énergie électrique reçue par la barre de distribution. La source d'énergie électrique peut être un générateur dans le cas d'une barre de distribution d'un boîtier de distribution électrique primaire, ou un boîtier de distribution électrique primaire dans le cas d'une barre de distribution d'un boîtier de distribution électrique secondaire. Les organes électriques auxquels est distribuée l'énergie électrique reçue par la barre de distribution peuvent être des sous réseaux de distribution secondaire ou des charges électriques.

Le remplacement du connecteur de puissance par une barre de distribution permet de réduire le coût et la masse du boîtier de distribution secondaire ou primaire, et d'augmenter les courants maximum permis pour l'entrée de puissance, une barre de distribution n'étant pas limitée en termes de fortes puissances.

De plus, les barres de distribution de puissance d'entrée étant connectées à plusieurs modules de puissance, le nombre de connexions câblées et réduit et par conséquent les protections dans la distribution, notamment pour la distribution primaire, sont considérablement réduites en nombre. En effet, il suffit d'une seule protection par barre de distribution.

En outre, les contraintes de positionnement de toute la connectique du harnais électrique sont réduites. En effet, les faisceaux de câbles du harnais électrique destinés sont connectés à une barre de distribution via un seul bornier couplé à la barre de distribution sur l'extérieur du boîtier. Les modules de puissance sont connectés à la barre de distribution par contact entre une connexion puissance du module et la barre de distribution d'un même. Aucune connexion directe entre un module de puissance et un faisceau de câbles du harnais électrique n'étant réalisée, aucun alignement n'est nécessaire.

Avantageusement, l'interface peut comprendre au moins une barre de distribution de puissance de sortie s'étendant dans au moins un premier logement de manière à pouvoir être connectée à au moins un module de puissance pour alimenter une charge ou un boîtier de distribution électrique.

L'utilisation d'une barre de distribution de puissance pour délivrer une puissance de sortie au boîtier de distribution permet d'utiliser des modules de puissance de fortes puissances tout en optimisant l'intégration de la connectique et la masse de la connectique en réduisant le nombre de connecteurs au total.

Dans un mode de réalisation, l'interface peut également comprendre au moins un connecteur individuel de puissance de sortie s'étendant dans un premier logement de manière à pouvoir être raccordé à un module de puissance pour alimenter une charge ou un boîtier de distribution électrique.

De cette manière, un boîtier de distribution peut être utilisé quelque soit la configuration de connexion sur les modules de puissance pour délivrer la puissance de sortie.

Le boîtier peut également comprendre dans un autre mode de réalisation au moins un connecteur individuel de puissance d'entrée s'étendant dans un premier logement de manière à pouvoir être raccordé à un module de puissance, le connecteur individuel d'entrée étant apte à recevoir un câble d'un harnais électrique.

Certains logements peuvent ainsi être dédiés aux modules de puissance tandis que d'autres sont dédiés aux modules de commande. Il est également possible dans cette configuration de séparer le boîtier en une partie de distribution et une partie de distribution secondaire, les premiers logements de la distribution primaire comprenant des barres de distribution de manière à pouvoir recevoir de fortes puissances tandis que les premiers ou seconds logements de la distribution secondaire comprennent des connecteurs individuels acceptant des puissances moins élevées.

De préférence, chaque premier logement comprend à la fois un connecteur individuel de puissance d'entrée et une barre de distribution de puissance d'entrée comprend un raccord électrique entre ladite barre de distribution de puissance d'entrée et ledit connecteur individuel de puissance d'entrée.

Dans une telle configuration, le boîtier peut recevoir des modules de puissance ayant des connecteurs d'entrée pour connecteurs individuels ou pour barre de distribution.

Avantageusement, le boîtier peut comprendre une carte mère de commande et un châssis principal comportant lesdits premiers et seconds logements, la carte mère étant montée sur l'extérieur du châssis principal et apte à être raccordée à au moins un premier ou second logement.

Une carte mère externe au boîtier de distribution permet d'avoir un châssis standard et de pouvoir gérer le nombre de modules supplémentaires du boîtier de distribution. De cette manière, tous les moyens électroniques sont indépendants et montés de manière amovible sur le boîtier.

De préférence, la carte mère de commande comprend un connecteur de puissance d'entrée. En intégrant à la carte de mère dans un connecteur standard ou inversement, les coûts et la masse totale du boîtier de distribution sont réduits.

Le boîtier peut également avantageusement comprendre au moins un châssis supplémentaire apte à être fixé audit châssis principal, le châssis supplémentaire comportant au moins un premier logement et/ou au moins un second logement, et la carte mère de commande étant montée en outre sur l'extérieur du châssis supplémentaire de manière à être également raccordée à au moins un premier logement et/ou un second logement du châssis supplémentaire.

La carte mère peut être adaptée en fonction de la configuration et du nombre de modules utilisés dans le boîtier, mais également en fonction du nombre de châssis supplémentaire fixés sur le châssis principal.

Selon un autre aspect de l'invention, il est proposé un système de distribution électrique comprenant au moins un boîtier de distribution électrique tel que défini ci-dessus.

Le système peut comprendre au moins un boîtier de distribution primaire connecté à au moins un boîtier de distribution secondaire, le boîtier de distribution primaire pouvant comprendre des modules de distributions secondaires.

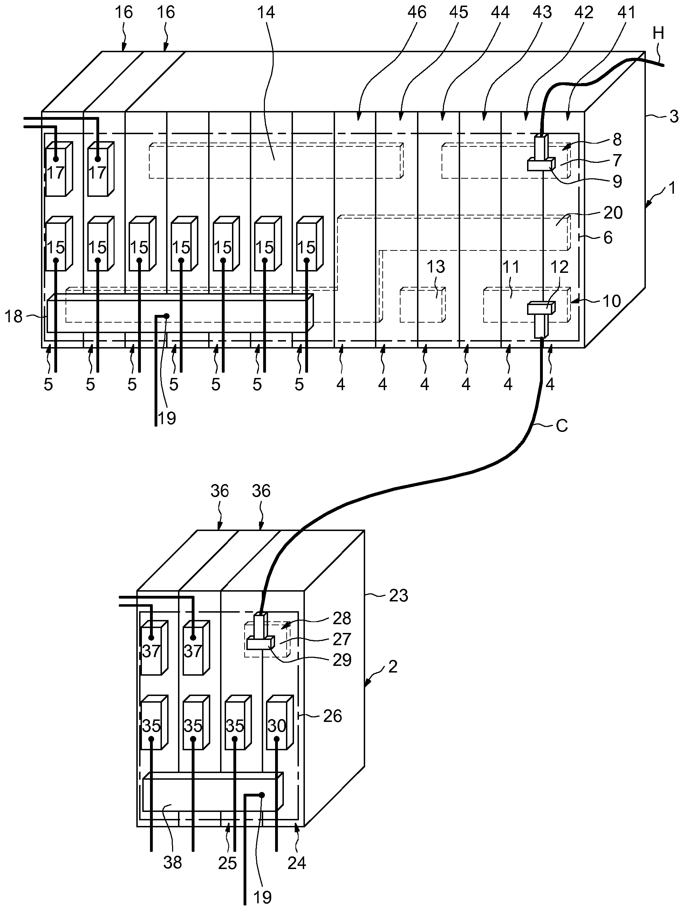

D'autres avantages et caractéristiques de l'invention apparaîtront à l'examen de la description détaillée de modes de réalisation, nullement limitatifs, et du dessin annexé, sur lequel la figure présente, de manière schématique, un système de distribution électrique comprenant un boîtier de distribution primaire 1 et un boîtier de distribution secondaire 2 selon un mode de réalisation de l'invention.

Le boîtier de distribution primaire 1 comprend un châssis principal 3 apte à être fixé sur un support ou une structure interne d'un véhicule tel qu'un aéronef. Le châssis principal 3 comprend six logements de puissance 4 et cinq logements de commande 5. Dans d'autres modes de réalisation, un boîtier de distribution primaire peut comprendre un autre nombre non nul de logements de puissance 4 et un autre nombre, qui peut être nul, de logements de commande 5. Les logements de puissance 4 sont configurés pour accueillir des modules de puissance tels que des cartes de puissance de type SSPC (Solid State Power Controller) et les logements de commande 5 sont configurés pour accueillir des modules de commande électronique tels que des cartes de commande.

Le boîtier de distribution primaire 1 comprend également une interface 6 réalisant l'interconnexion entre les différents modules de puissance et de commande et des organes électriques externes. Les organes électriques externes sont, d'une part, des sources d'énergie électrique, et, d'autre part, des charges électriques ou des sous réseaux de distribution d'énergie électrique, notamment le boîtier de distribution secondaire 2.

L'interface 6 du boîtier de distribution primaire 1 comprend une première barre de distribution 7 de forte puissance d'entrée s'étendant sur quatre logements de puissance 4 dédiés aux fortes puissances et référencés 41 à 44. La première barre de distribution 7 permet d'alimenter ainsi jusqu'à quatre modules de insérés dans chacun des quatre logements de forte puissance 41 à 44 avec un courant important.

La première barre de distribution 7 comprend une barre conductrice 8 et un bornier 9 permettant de raccorder électriquement la barre conductrice 8 à un câble *H* d'un harnais électrique non représenté, le câble *H* du faisceau électrique étant raccordé par ailleurs, dans cet exemple de réalisation, à un générateur de courant. La première barre de distribution 7 est agencée de manière à avoir la barre conductrice 8 sur l'intérieur du châssis principal 3 du boîtier de distribution primaire 1 et le bornier 9 sur l'extérieur du châssis principal 3.

La première barre de distribution 7 peut bien évidemment être couplée à une autre source d'énergie d'un générateur de courant.

La première barre de distribution 7 ne nécessite qu'une seule protection étant donné qu'il n'y a qu'un seul câble qui y est connecté, alors qu'elle peut alimenter jusqu'à quatre modules de puissance puisqu'elle s'étend sur quatre premiers logements 4.

Dans cet exemple de réalisation, pour réduire le coût et la masse du boîtier de distribution primaire 1, la première barre de puissance 7 n'est pas doublée avec des connecteurs individuels de puissance d'entrée pour chacun des logements de forte puissance 41 à 44.

Dans un autre mode de réalisation, il est possible de doubler la première barre de distribution 7 de connecteurs individuels de puissance d'entrée de manière à pouvoir utiliser aussi bien des modules de puissance configurés pour être raccorder électriquement en entrée à l'aide d'une barre de distribution que des modules de puissance configurés pour être connecter à la puissance d'entrée à l'aide de connecteur individuel de puissance d'entrée.

Dans ce cas, les logements de puissance 4 doivent comprendre en outre des détrompeurs pour ajuster la position des modules de puissance lors de leur insertion dans les logements de puissance 4 pour s'assurer de la connexion du module de puissance avec le connecteur individuel.

Lorsque le module de puissance est couplé à la puissance d'entrée à l'aide d'une barre de distribution uniquement, les contraintes de positionnement du harnais électrique sont réduites, car les faisceaux de câbles du harnais électrique sont connectés à la barre de distribution via un seul bornier et les modules de puissance sont connectés à la barre de distribution par contact entre une connexion du module de puissance et la barre conductrice de la barre de distribution.

L'utilisation d'une barre de distribution plutôt qu'un connecteur individuel pour acheminer la puissance d'entrée permet d'utiliser des courants plus importants pour l'entrée de puissance par rapport aux puissances permises par des connecteurs individuels.

De plus, les barres de distribution de puissance d'entrée étant connectées à plusieurs modules de puissance, le nombre de connexions câblées est réduit et par conséquent le nombre de protections dans le boîtier de distribution primaire est considérablement réduit. En effet, il suffit d'une seule protection par barre de distribution.

L'interface 6 du boîtier de distribution primaire comprend en outre une première barre de distribution de puissance de sortie 10 s'étendant sur les trois premiers 41 à 43 des quatre logements de fortes puissances 41 à 44 de manière à pouvoir raccorder jusqu'à trois modules de puissance insérés dans les trois premiers logements de fortes puissances 41 à 43 à une charge électrique ou un boîtier de distribution secondaire.

Dans le mode de réalisation illustré, la première barre de distribution de puissance de sortie 10 comprend une barre conductrice 11 montée sur l'intérieur du châssis principal 3 et un bornier 12 monté sur l'extérieur du châssis principal 3 et en couplage électrique avec la barre conductrice 11. Le bornier 12 permet de coupler via un câble de connexion *C* une entrée de puissance du boîtier de distribution secondaire 2 et ainsi d'alimenter le boîtier de distribution secondaire 2 en énergie électrique.

L'utilisation d'une barre de distribution de puissance de sortie pour délivrer une puissance de sortie au boîtier de distribution secondaire 3 permet d'utiliser des modules de puissance de fortes puissances tout en réduisant le nombre de connecteurs au total et le nombre de protections électriques nécessaires.

Les deux derniers logements de puissance 45 et 46 sont dédiés aux puissances secondaires plus faibles que les puissances délivrées dans les logements de fortes puissances 41 à 44.

Dans ce mode de réalisation, le boîtier de distribution primaire 3 comprend ainsi une partie de distribution primaire comprenant les logements de puissance 41 à 44 aptes à recevoir des fortes puissances et une partie de distribution secondaire comprenant les logements de puissance secondaire 45 et 46 aptes à recevoir des puissances plus faibles.

L'interface 6 comprend également une barre de distribution de puissance interne 13 s'étendant entre le quatrième logement de fortes puissances 44 et le premier logement de puissance secondaire 45. La barre de distribution de puissance interne 13 est destinée à être couplée à une sortie de puissance d'un module de puissance inséré dans le quatrième logement de fortes puissances 44 et à alimenter ainsi à partir de la puissance délivrée en sortie de ce module de puissance un module de puissance inséré dans le premier logement de puissance secondaire 45.

L'interface 6 comprend en outre une barre de distribution de puissance secondaire 14 s'étendant sur les deux logements de puissance secondaire 45 et 46 et sur les logements de commande 5. La barre de distribution de puissance secondaire 14 est raccordée électriquement à la barre de distribution interne 13. Le raccordement électrique peut être réalisée via le module de puissance inséré dans le premier logement de puissance secondaire 45 ou bien via une connexion électrique directement réalisée entre les deux barres de distribution 13 et 14 sur l'interface 6. La barre de distribution de puissance secondaire 14 permet d'alimenter en électricité les modules de commande insérés dans les logements de commande 5 et le module de puissance inséré dans le second logement de puissance secondaire 46.

L'interface 6 comprend un connecteur individuel de sortie de commande 15 monté sur le châssis principal 3 en regard de chaque logement de commande 5 de manière à pouvoir être connecté en sortie d'un module de commande inséré dans un des cinq logements de commande 5. Les connecteurs individuels de sortie de commande 15 sont destinés à être connectés à des charges électriques à commander ou des boîtiers de distribution.

Dans un autre mode de réalisation, l'interface 6 peut comprendre également comprendre des connecteurs individuels de puissance de sortie disposés chacun dans un logement de puissance de manière à pouvoir être raccordé à un module de puissance pour alimenter une charge ou un boîtier de distribution électrique secondaire. Dans cette configuration, pour les logements de puissance 4 comprenant à la fois une barre de distribution de puissance de sortie et un connecteur individuel de puissance de sortie, le boîtier de distribution peut être utilisé quelque soit la configuration de connexion des modules de puissance pour délivrer la puissance de sortie.

Le boîtier de distribution primaire 1 comprend en outre, dans le mode de réalisation illustré, deux châssis supplémentaires 16 fixés sur le châssis principal 3. Chacun des châssis supplémentaires comportent un logement de commande 5.

Le logement de commande 5 de chacun des deux châssis supplémentaires 16 comprend un connecteur individuel de puissance d'entrée 17 disposé sur une face extérieure du châssis supplémentaire 16 et arrangé de manière à pouvoir être raccordé à un module de commande inséré dans le logement de commande 5 correspondant, le connecteur individuel d'entrée 17 étant apte à recevoir un câble du harnais électrique.

Dans un autre mode de réalisation il est possible de remplacer ou de doubler le connecteur individuel de puissance d'entrée 17 avec une barre de distribution de puissance d'entrée comprenant une barre conductrice et un bornier apte à être couplé au câble d'un harnais électrique.

Le logement de commande 5 de chacun des deux châssis supplémentaires 16 comprend en outre un connecteur individuel de commande de sortie 15 disposé sur une face extérieure du châssis supplémentaire 16 et arrangé de manière à pouvoir être raccordé à un module de commande inséré dans le logement de commande 5 correspondant. Le connecteur individuel de sortie de commande 15 de du logement de commande 5 chaque châssis supplémentaire 16 est destiné à être connecté à des charges électriques à commander ou des boîtiers de distribution.

L'interface 6 du boîtier de distribution primaire 1 comprend une carte mère de commande 18. Dans ce mode de réalisation, la carte mère de commande 18 est montée sur l'extérieur du boîtier et notamment sur l'extérieur du châssis principal 3 et des châssis supplémentaires 16. Ainsi de cette manière, une seule carte mère de commande 18 est utilisée pour raccorder à la fois les logements de commande 5 du châssis principal 3 et les logements de commande 5 des deux châssis supplémentaires 16 à une unité de commande externe.

L'interface 6 est configurée de manière à coupler la carte mère de commande 18 externe à une carte de connexion de commande 20 montée sur l'intérieure du châssis principal 3 et permettant de coupler les modules de puissance et les modules de commande à la carte mère de commande 18.

L'externalité de la carte mère de commande 18 permet au boîtier de distribution primaire 1 d'avoir un châssis principal 3 standard et de pouvoir choisir la carte mère de commande 18 en fonction du nombre de modules de commandes utilisés sur le châssis principal 3 et sur les châssis supplémentaires 16 fixés au châssis principal 3.

La carte mère de commande 18 comprend un connecteur de puissance d'entrée 19.

Le boîtier de distribution secondaire 2 du système de distribution illustré sur cette figure comprend également un châssis principal 23 et des châssis supplémentaires 36 fixés sur le châssis principal 23, et une interface 26. Chaque châssis supplémentaire 36 comprend, comme pour le boîtier de distribution primaire 1, un logement de commande 25 comportant chacun un connecteur individuel de puissance d'entrée 37 et un connecteur individuel de commande 35.

Le châssis principal 23 du boîtier de distribution secondaire 2 comprend une partie de puissance comportant un logement de puissance 24 et une partie de commande comportant un logement de commande 25. Monté sur le châssis principal 23, l'interface 26 comprend en outre une barre de distribution de puissance d'entrée composée d'une barre conductrice 28 agencée sur l'intérieur du châssis principal 23 et un bornier 29 monté sur l'extérieur du châssis principal 23 et couplé électriquement à la barre conductrice 28. Le bornier 29 est raccordé électriquement à la barre de distribution de puissance de sortie 10 du boîtier de distribution primaire 1 qui alimente ainsi le boîtier de distribution secondaire 2 en électricité.

L'interface 26 du boîtier de distribution secondaire 2 comprend en outre un connecteur individuel de sortie de puissance 30 agencé de manière à être en regard du logement de puissance 24 du boîtier de distribution secondaire 2 et un connecteur de commande de sortie 35 disposé de manière à être en regard du logement de commande 25 agencé dans le châssis principal 23.

L'interface 26 du boîtier de distribution secondaire 2 comprend également une carte mère de commande 38 monté sur une face externe du châssis principal 23 et des deux châssis supplémentaires 36 de manière être raccordé aux logements de commande 25 du châssis principal 23 et des châssis supplémentaires 36 ainsi qu'au logement de puissance 24 du châssis principal 23.

L'exemple de mode de réalisation illustré sur cette figure n'est pas limitatif, et toute combinaison de caractéristique décrite entre les boîtiers de distribution secondaire 2 et primaire 1 notamment ne sort pas du cadre de l'invention.

L'invention propose ainsi un système électrique comprenant au moins un boîtier de distribution optimiser en termes de poids, de coût, d'utilisation et de maintenance, en utilisant une barre de distribution comme connectique entre les modules insérés dans le boîtier et les éléments électriques externes au boîtier de distribution.

## Revendications

1. Boîtier de distribution électrique (1, 2) pour aéronef comprenant des premiers logements (4, 24) pour accueillir des modules de puissance et des seconds logements (5, 25) pour accueillir des modules de commande électronique, et une interface (6, 26) permettant de réaliser les connexions entre les différents modules et des éléments électriques externes, **caractérisé en ce que** l'interface (6, 26) comprend au moins une barre de distribution de puissance d'entrée (7, 27) s'étendant dans au moins un premier logement (4, 24) de manière à pouvoir être raccordée à au moins un module de puissance, une barre de distribution d'entrée (7, 27) étant apte à être raccordée à un câble d'un harnais électrique de manière à connecter au moins un module de puissance au harnais électrique.

2. Boîtier (1) selon la revendication 1, **caractérisé en ce que** l'interface (6) comprend au moins une barre de distribution de puissance de sortie (10) s'étendant dans au moins un premier logement (4) de manière à pouvoir être connectée à au moins un desdits modules de puissance pour alimenter une charge ou un boîtier de distribution électrique.

3. Boîtier (2) selon l'une des revendications 1 ou 2, **caractérisé en ce que** l'interface (26) comprend au moins un connecteur individuel de puissance de sortie (30) s'étendant dans un premier logement (24) de manière à pouvoir être raccordé à un module de puissance pour alimenter une charge ou un boîtier de distribution électrique.

4. Boîtier (1, 2) selon l'une des revendications 1 à 3, **caractérisé en ce qu'**il comprend au moins un connecteur individuel de puissance d'entrée (17, 37) s'étendant dans un premier logement (4, 24) d'un châssis supplémentaire de manière à pouvoir être raccordé à un module de puissance, le connecteur individuel d'entrée (17, 37) étant apte à recevoir un câble d'un harnais électrique.

5. Boîtier selon la revendication 4, dans lequel chaque premier logement comprenant à la fois un connecteur individuel de puissance d'entrée et une barre de distribution de puissance d'entrée comprend un bornier apte à être couplé au câble du harnais électrique.

6. Boîtier (1, 2) selon l'une des revendications 1 à 5, **caractérisé en ce qu'**il comprend une carte mère de commande (18, 38) et un châssis principal (3, 23) comportant lesdits premiers et seconds logements (4 ou 24, 5 ou 25), la carte mère (18, 38) étant montée sur l'extérieur du châssis principal (3, 23) et apte à être raccordée à au moins un premier ou second logement (4 ou 24, 5 ou 25).

7. Boîtier (1, 2) selon la revendication 6, dans lequel la carte mère de commande (18, 38) comprend un connecteur de puissance d'entrée (19, 39).

8. Boîtier (1, 2) selon l'une des revendications 5 à 7, **caractérisé en ce que** le châssis supplémentaire (16, 36) apte à être fixé à un châssis principal (3, 23), le châssis supplémentaire (16, 36) comportant au moins un premier logement (4, 24) et/ou au moins un second logement (5, 25), et la carte mère de commande (18, 38) étant montée en outre sur l'extérieur du châssis supplémentaire (16, 36) de manière à être également raccordée à au moins un premier logement (4, 24) et/ou un second logement (5, 25) du châssis supplémentaire (16, 36).

9. Système de distribution électrique comprenant au moins un boîtier de distribution électrique (1, 2) selon l'une des revendications 1 à 8.

## Patentansprüche

1. Stromverteilungsbox (1, 2) für ein Flugzeug, umfassend erste Aufnahmen (4, 24) zum Aufnehmen der Leistungsmodule und zweite Aufnahmen (5, 25) zum Aufnehmen der Module zur elektronischen Steuerung und eine Schnittstelle (6, 26), die es ermöglicht, Verbindungen zwischen den verschiedenen Modulen und externen elektrischen Elementen auszuführen, **dadurch gekennzeichnet, dass** die Schnittstelle (6, 26) mindestens eine Eingangsleistungsverteilungsschiene (7, 27) umfasst, die sich in mindestens einer ersten Aufnahme (4, 24) erstreckt, so dass sie an mindestens ein Leistungsmodul angeschlossen werden kann, wobei die Eingangsverteilungsschiene (7, 27) geeignet ist, an ein Kabel eines Kabelbaums angeschlossen zu werden, so dass mindestens ein Leistungsmodul mit dem Kabelbaum verbunden wird.

2. Box (1) nach Anspruch 1, **dadurch gekennzeichnet, dass** die Schnittstelle (6) mindestens eine Ausgangsleistungsverteilungsschiene (10) umfasst, die sich in mindestens einer ersten Aufnahme (4) erstreckt, so dass sie mit mindestens einem der Leistungsmodule verbunden werden kann, um eine Last oder eine Stromverteilungsbox zu versorgen.

3. Box (2) nach einem der Ansprüche 1 oder 2, **dadurch gekennzeichnet, dass** die Schnittstelle (26) mindestens einen individuellen Ausgangsleistungssteckverbinder (30) umfasst, der sich in einer ersten Aufnahme (24) erstreckt, so dass er an ein Leistungsmodul angeschlossen werden kann, um eine Last oder eine Stromverteilungsbox zu versorgen.

4. Box (1, 2) nach einem der Ansprüche 1 bis 3, **dadurch gekennzeichnet, dass** sie mindestens einen individuellen Eingangsleistungssteckverbinder (17, 37) umfasst, der sich in einer ersten Aufnahme (4, 24) eines zusätzlichen Rahmens erstreckt, so dass er an ein Leistungsmodul angeschlossen werden kann, wobei der individuelle Eingangssteckverbinder (17, 37) geeignet ist, ein Kabel eines Kabelbaums aufzunehmen.

5. Box nach Anspruch 4, bei dem jede erste Aufnahme, die sowohl einen individuellen Eingangsleistungssteckverbinder und eine Eingangsleistungsverteilungsschiene umfasst, einen Anschlussblock umfasst, der geeignet ist, mit dem Kabel des Kabelbaums gekoppelt zu werden.

6. Box (1, 2) nach einem der Ansprüche 1 bis 5, **dadurch gekennzeichnet, dass** sie eine Steuerungshauptplatine (18, 38) und einen Hauptrahmen (3, 23), der die ersten und zweiten Aufnahmen (4 oder 24, 5 oder 25) beinhaltet, umfasst, wobei die Hauptplatine (18, 38) an der Außenseite des Hauptrahmens (3, 23) montiert ist und geeignet ist, an mindestens eine erste oder zweite Aufnahme (4 oder 24, 5 oder 25) angeschlossen zu werden.

7. Box (1, 2) nach Anspruch 6, bei der die Steuerungshauptplatine (18, 38) einen Eingangsleistungssteckverbinder (19, 39) umfasst.

8. Box (1, 2) nach einem der Ansprüche 5 bis 7, **dadurch gekennzeichnet, dass** der zusätzliche Rahmen (16, 36) geeignet ist, an einem Hauptrahmen (3, 23) befestigt zu werden, wobei der zusätzliche Rahmen (16, 36) mindestens eine erste Aufnahme (4, 24) und/oder mindestens eine zweite Aufnahme (5, 25) beinhaltet, und wobei die Steuerungshauptplatine (18, 38) ferner an der Außenseite des zusätzlichen Rahmens (16, 36) montiert ist, so dass sie auch an mindestens eine erste Aufnahme (4, 24) und/oder eine zweite Aufnahme (5, 25) des zusätzlichen Rahmens (16, 36) angeschlossen ist.

9. Stromverteilungssystem mit mindestens einer Stromverteilungsbox (1, 2) nach einem der Ansprüche 1 bis 8.

## Claims

1. Electrical distribution box (1, 2) for an aircraft comprising first housings (4, 24) for receiving power modules and second housings (5, 25) for receiving electronic control modules, and an interface (6, 26) for making the connections between the various modules and external electrical elements, **characterized in that** the interface (6, 26) comprises at least one input power busbar (7, 27) extending into at least a first housing (4, 24) so as to be able to be connected to at least one power module, an input busbar (7, 27) being capable of being connected to a cable of a wiring harness in such a way as to connect at least one power module to the electrical harness.

2. Box (1) according to Claim 1, **characterized in that** the interface (6) comprises at least one output power busbar (10) extending into at least a first housing (4) so as to be able to be connected to at least one of said power modules in order to supply a load or an electrical distribution box.

3. Box (2) according to either one of Claims 1 or 2, **characterized in that** the interface (26) comprises at least one individual output power connector (30) extending into a first housing (24) so as to be able to be connected to a power module in order to supply a load or an electrical distribution box.

4. Box (1, 2) according to any one of Claims 1 to 3, **characterized in that** it comprises at least one individual input power connector (17, 37) extending into a first housing (4, 24) of an additional frame so as to be able to be connected to a power module, the individual input connector (17, 37) being capable of receiving a cable of a wiring harness.

5. Box according to Claim 4, in which each first housing comprising both an individual input power connector and an input power busbar comprises a terminal block capable of being coupled to the cable of the wiring harness.

6. Box (1, 2) according to any one of Claims 1 to 5, **characterized in that** it comprises a control motherboard (18, 38) and a main frame (3, 23) including said first and second housings (4 or 24, 5 or 25), the motherboard (18, 38) being mounted on the outside of the main frame (3, 23) and being capable of being connected to at least a first or second housing (4 or 24, 5 or 25).

7. Box (1, 2) according to Claim 6, in which the control motherboard (18, 38) comprises an input power connector (19, 39).

8. Box (1, 2) according to any one of Claims 5 to 7, **characterized in that** the additional frame (16, 36) capable of being fixed to a main frame (3, 23), the additional frame (16, 36) including at least a first housing (4, 24) and/or at least a second housing (5, 25), and the control motherboard (18, 38) being mounted additionally on the outside of the additional frame (16, 36) so as to be also connected to at least a first housing (4, 24) and/or a second housing (5, 25) of the additional frame (16, 36).

9. Electrical distribution system comprising at least one electrical distribution box (1, 2) according to any one of Claims 1 to 8.
